# EUROPEAN PATENT APPLICATION

(11) **EP 1 614 766 A1**
(43) Date of publication of application: **11.01.2006**
(21) Application number: 04727675.3
(22) Date of filing: 15.04.2004
(51) Int. Cl.: C23C 14/34, C23C 14/58, C23C 14/06, C23C 30/00, C23F 1/44, H01M 4/88, H01M 4/90, H01M 14/00, B01J 35/02

(54) **METHOD FOR FORMING POROUS THIN FILM**

(30) Priority: 16.04.2003 JP 2003111003
(71) Applicant: Bridgestone Corporation, Tokyo 104-0031 (JP)
(72) Inventor: IWABUCHI, Yoshinori Tech. Center Bridgestone Corp., Kodaira-shi, Tokyo 1878531 (JP); SUGI, Shinichiro Tech. Center Bridgestone Corp., Kodaira-shi, Tokyo 187-8531 (JP); ONO, Shingo Technical Center Bridgestone Corp., Kodaira-shi, Tokyo 187-8531 (JP); SUGIYAMA, Hideo Technical Center Bridgestone Corp., Kodaira-shi, Tokyo 1878531 (JP); YOSHIKAWA, Masato Tech. Center BridgestoneCorp., Kodaira-shi, Tokyo 187-8531 (JP)
(74) Representative: Whalley, Kevin
(86) International application number: PCT/JP2004/005378
(87) International publication number: WO 2004/092440

(57) **Abstract**

A method for forming a porous thin film is **characterized by** formation of a composite thin film on a substrate, in which film a metal portion composed of a first metal component and a metal compound portion composed of a compound of a second metal component which is different from the first metal component are mixed-dispersed, and following removal of the metal portion from the composite thin film. A method for forming a porous thin film is alternatively **characterized by** formation of a composite thin film on a substrate, in which film a first metal portion composed of a first metal component and a second metal portion composed of a second metal component which is different from the first metal component are mixed-dispersed, and following removal of either one of the metal portions from the composite thin film.

## Description

### TECHNICAL FIELD

This invention relates to a method for forming a porous thin film such as a porous metal compound thin film such as a porous metal oxide thin film useful in an electrode of a solar cell, a photocatalyst or the like or a porous metal thin film useful in a catalyst layer of a fuel cell or in a like layer.

### BACKGROUND ART

Owing to large specific surface areas, porous thin films of a metal oxide or a metal are suited for members in which many active sites (sites of action) are required to be distributed per unit volume. Accordingly, they are applied to members such as electrodes and catalysts that require many active sites (sites of action) in limited volumes, and have found utility in fields such as electrodes for solar cells and catalysts such as photocatalysts.

In solar cells, porous metal oxide thin films are used as metal oxide semiconductor electrodes, and solar cells making use of an oxide semiconductor, which is sensitized with an organic dye, without using silicon as a light-transforming material are known (JP-A 1-220308, JP-A 5-504023). JP-A 10-92477, on the other hand, discloses a solar cell making use of oxide semiconductor films, each of which is composed of a baked product of an aggregate of oxide semiconductor microparticles, as electrodes of a metal oxide semiconductor sensitized with an organic dye. In this patent publication, the semiconductor films are each formed by coating slurry of oxide semiconductor microparticles on a transparent electrode, drying the slurry, and then conducting baking.

According to the above-described method, a porous metal oxide thin film, which is a baked product of an aggregate of oxide semiconductor microparticles, is formed by the so-called sol-gel process. For the provision of electrodes made of a metal oxide semiconductor sensitized with an organic dye and having a high photoenergy conversion efficiency, however, it is necessary to provide porous metal oxide thin films themselves with a still larger specific surface area, resulting in an outstanding demand for a method capable of forming a porous metal oxide semiconductor thin film equipped with a large specific surface area.

On the other hand, metal oxides such as TiO₂, ZnO₂ and WO₃ are known to have photocatalytic functions that absorb ultraviolet rays to give effects such as superhydrophilization and oxidation, and are used widely in water purification, air purification, deodorization, oil degradation and the like. Upon their applications, it is a frequent practice to form and immobilize a metal oxide, which has such photocatalytic effects, in the form of a film on a substrate.

As methods for forming such a metal oxide thin film as described above, there are, for example, a method that forms a film by mixing a resin, rubber or the like as a binder with powder, coating the resulting mixture on a substrate, and then sintering the thus-coated mixture; a method that forms a film by a so-called sol-gel process, namely, by forming a gel coating film with a metal alkoxide solution and then baking the gel coating film; and a method that forms a metal oxide thin film by sputtering (JP-A 11-92176).

In the case of metal oxide thin films to be used as photocatalysts, it is also effective for the provision of metal oxide thin films, which are imparted with high catalytic activities by a small amount of the metal oxide, to make the metal oxide thin films porous such that active sites are highly distributed. According to such conventional processes as mentioned above, however, no porous thin film has been obtained with a sufficient specific surface area. Similar to metal oxide semiconductor thin films for solar cells, there is an outstanding demand for a method for forming a porous metal oxide thin film having a still higher specific surface area.

In a fuel cell, a catalyst layer is arranged between an electrolyte film and a porous substrate. Employed generally for the formation of this catalyst layer is a process which includes coating supported catalyst particles, which are formed of a metal such as platinum supported on activated carbon or the like, on a porous substrate such as a carbon sheet. For the improvement of the power generation efficiency of a fuel cell, however, it is necessary to achieve a still higher distribution of active catalyst sites.

### DISCLOSURE OF INVENTION

With the foregoing circumstances in view, the present invention has as objects thereof the provision of methods capable of forming a porous metal oxide thin film and porous metal thin film having a high specific surface area, which are suited as a metal oxide thin film and metal thin film, respectively, such as a metal oxide semiconductor thin film for a solar cell electrode, a photocatalyst thin film and a catalyst layer for a fuel cell, each of which is used in a form formed on a substrate.

The present inventors have proceeded with an extensive investigation to achieve the above-described objects. As a result, it has been found that a porous thin film formed by forming on a substrate a composite thin film, in which metal portions composed of a first metal component and metal compound portions composed of a compound of a second metal component different from the first metal component are randomly distributed together, and then removing only the metal portions from the composite thin film is equipped with a high specific surface area. Especially, an application of this process as a method for forming a metal oxide semiconductor thin film for a solar cell electrode can provide an organic-dye-sensitized metal oxide semiconductor electrode having a high photoenergy conversion efficiency and an application of this process as a method for forming a photocatalyst thin film can provides a photocatalyst thin film having a high specific surface area and containing highly-distributed active sites.

It has also been found that a porous thin film formed by forming on a substrate a composite thin film, in which first metal portions composed of a first metal component and second metal portions composed of a second metal component different from the first metal component are randomly distributed together, and then removing only one metal portions of the first metal portions and second metal portions is equipped with a high specific surface area. Especially, the formation of a porous metal thin film as a catalyst layer by applying this process as a method for the formation of a catalyst layer for a fuel cell makes it possible to highly distribute active catalyst sites and the use of the catalyst layer makes it possible to provide the fuel cell with an improved power generation efficiency. These findings have led to the completion of the present invention.

Described specifically, the present invention provides the following methods for the formation of porous thin films.
Claim 1: A method for forming a porous thin film, including the step of forming on a substrate a composite thin film in which metal portions composed of a first metal component and metal compound portions composed of a compound of a second metal component different from the first metal component are randomly distributed together, and then, removing only the metal portions from the composite thin film.
Claim 2: A method for forming a porous thin film according to claim 1, wherein the composite thin film is formed by arranging a metal target composed of the first metal component and a metal compound target composed of the compound of the second metal component different from the first metal component in a chamber, and simultaneously applying electric powers to the targets to perform sputtering.
Claim 3: A method for forming a porous thin film according to claim 1 or 2, wherein the metal compound is a metal oxide, metal nitride or metal oxynitride.
Claim 4: A method for forming a porous thin film according to any one of claims 1 to 3, wherein the first metal component is at least one metal selected from the group consisting of Zn, Cr, Al, Cu, Si, Ti, Ag, Mn, Fe, Co, Cd, Ni, Zr, Nb, Mo, In, Sn, Sb, Hf, Ta, W, and Mg, and the second metal component is at least one metal different from the first metal component and selected from the group.
Claim 5: A method for forming a porous thin film according to any one of claims 1 to 3, wherein the first metal component is at least one metal selected from the group consisting of Zn, Cr, Al, Cu, Si, Ti, Ag, Mn, Fe, Co, Cd, Ni, Zr, Nb, Mo, In, Sn, Sb, Hf, Ta, W, and Mg, and the second metal component is at least one metal different from the first metal component and selected from the group consisting of Zn, Ti, Nb, In, Sn, Sb and W.
Claim 6: A method for forming a porous thin film according to any one of claims 1 to 3, wherein the first metal component is at least one metal selected from the group consisting of Zn, Cr, Al, Cu, Si, Ag, Mn, Fe, Co, Cd, Ni, Zr, Nb, Mo, In, Sn, Sb, Hf, Ta, W, and Mg, and the second metal component is Ti.
Claim 7: A method for forming a porous thin film according to any one of claims 1 to 6, wherein the first metal component and second metal component are in such a combination that only the metal portions can be dissolved out of the composite thin film in an aqueous acid solution or aqueous alkali solution.
Claim 8: A method for forming a porous thin film according to claim 7, wherein the removal of the metal portions includes dissolving the metal portions with the aqueous acid solution or aqueous alkali solution.
Claim 9: A method for forming a porous thin film according to any one of claims 1 to 8, further includes the step of conducting baking after the metal portions are removed.
Claim 10: A method for forming a porous thin film, including the step of forming on a substrate a composite thin film in which first metal portions composed of a first metal component and second metal portions composed of a second metal component different from the first metal component are randomly distributed together, and then, removing only one metal portions of the first metal portions and the second metal portions from the composite thin film.
Claim 11: A method for forming a porous thin film according to claim 10, wherein the composite thin film is formed by arranging a first metal target composed of the first metal component and a second metal target composed of the second metal component different from the first metal component in a chamber, and simultaneously applying electric powers to the targets to perform sputtering.
Claim 12: A method for forming a porous thin film according to claim 10 or 11, wherein the first metal component is at least one metal selected from the group consisting of Pt, Ru, Ir, Rh, Zn, Cr, Al, Cu, Si, Ti, Ag, Mn, Fe, Co, Cd, Ni, Zr, Nb, Mo, In, Sn, Sb, Hf, Ta, W, and Mg, and the second metal component is at least one metal different from the first metal component and selected from the group.
Claim 13: A method for forming a porous thin film according to any one of claims 10 to 12, wherein the first metal component and second metal component are in such a combination that the metal portions of only one metal component can be dissolved out of the composite thin film in an aqueous acid solution or aqueous alkali solution.
Claim 14: A method for forming a porous thin film according to claim 13, wherein the removal of the metal portions includes dissolving only one metal portions of the first metal portions and second metal portions with the aqueous acid solution or aqueous alkali solution.

According to the present invention, it is possible to a porous metal oxide thin film and porous metal thin film having a high specific surface area, which are suited as a metal oxide thin film and metal thin film, respectively, such as a metal oxide semiconductor thin film for a solar cell electrode, a photocatalyst thin film and a catalyst layer for a fuel cell, each of which is used in a form formed on a substrate.

### BRIEF DESCRIPTION OF DRAWINGS

FIG. 1 is a simplified schematic plan view of a sputtering apparatus for forming a composite thin film by sputtering in a method according to one example of a first embodiment of the present invention for the formation of a porous thin film.
FIG. 2 is a simplified schematic plan view of a sputtering apparatus for forming a composite thin film by sputtering in a method according to one example of a second embodiment of the present invention for the formation of a porous thin film.

### BEST MODE FOR CARRYING OUT THE INVENTION

The present invention will hereinafter be described in further detail.

The method according to the first embodiment of the present invention for the formation of a porous thin film forms the porous thin film by forming on a substrate a composite thin film in which metal portions composed of a first metal component and metal compound portions composed of a compound of a second metal component different from the first metal component are randomly distributed together, and then, removing only the metal portions from the composite thin film.

In the first embodiment, no particular limitation is imposed on the kind of the substrate to be processed, and a desired substrate can be selected depending on the application purpose of the porous thin film. When forming a metal oxide semiconductor thin film for use as a solar cell electrode, a glass substrate coated with ITO or fluorine-doped tin oxide can be used as a substrate, for example. When forming a photocatalyst thin film, a ceramic, resin or the like can be applied. In this case, ceramic substrates can include glass substrates such as non-alkali glass substrates and silica glass substrates, while resin substrates can include substrates of hydrocarbon resins such as polyethylene, polypropylene, and polystyrene, substrates of polyesters such as polyethylene terephthalate, polyamide resin substrates, and polycarbonate resin substrates.

In the first embodiment, the composite thin film can be formed by arranging a metal target composed of the first metal component and a metal compound target composed of the compound of the second metal component different from the first metal component or arranging a metal target composed of the first metal component and a metal compound target composed of a compound of the second metal component different from the first metal component as a combination of a metal component hard to form a compound such as an oxide, nitride or oxynitride and a metal component easy to form the above-described compound, in a chamber, and simultaneously applying electric powers to these targets to perform sputtering.

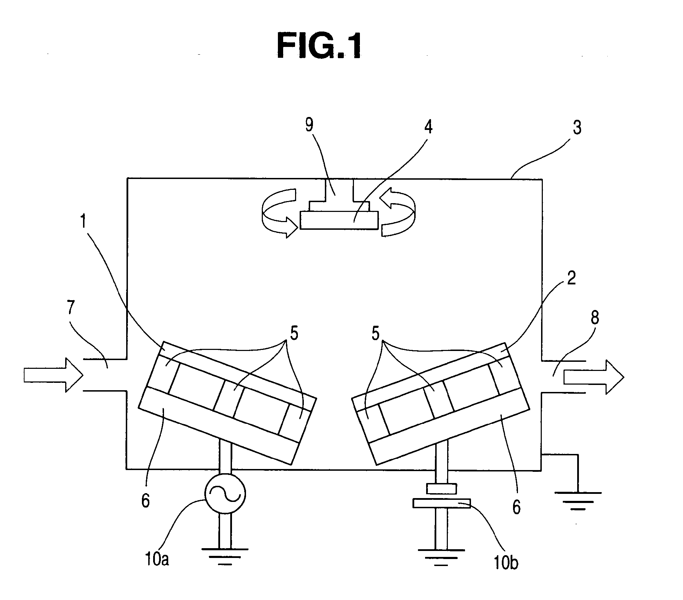

As such a method, a composite thin film can be formed, for example, as illustrated in FIG. 1, by conducting sputtering while rotating a substrate 4, on which the composite thin film is to be formed, with a film-forming surface being directed toward sputtering surfaces of a metal target 1 composed of a first metal component and a metal compound target 2 composed of a compound of a second metal component different from the first metal component in a sputtering atmosphere formed by arranging the targets 1, 2 in a chamber 3 and simultaneously applying electric powers to these targets 1, 2 (the sputtering atmosphere being formed primarily in a space extending from the sputtering surfaces of the metal target 1 and metal oxide target 2 toward the side of the substrate 4). It is to be noted that in FIG. 1, there are indicated magnets 5, target electrodes 6, a gas inlet port 7, a gas outlet port (evacuation port) 8, a rotary support 9, an RF power supply 10a, and a DC power supply 10b.

The formation of a composite thin film by such a method makes it possible to obtain the composite thin film in such a form that fine metal portions composed of the first metal component and fine metal compound portions composed of the second metal component are highly distributed together. As the substrate is rotated especially in the illustrated example, the state of distribution of the metal portions and the metal oxide portions in the direction of the plane of the composite thin film can be controlled uniform. In this case, it is also possible to change the ratio of the metal portions to the metal oxide portions by altering the electric powers to be applied to the respective targets. Further, the method can also be applied to the roll-to-roll processing of a film substrate or the in-line coating of a glass substrate by arranging the first and the second targets as rectangular targets in positions inclined at predetermined angles.

In the first embodiment, a metal oxide, a metal nitride, or a metal oxynitride can be preferably mentioned as a metal compound.

As sputtering gas, an inert gas such as helium or argon can be used. Upon forming a composite thin film by using targets of metal oxides, metal nitrides or metal oxynitrides, it is also possible to make combined use of oxygen gas in the case of the use of the metal oxides, nitrogen gas in the case of the use of metal nitrides, or oxygen gas, nitrogen gas or nitric oxide gas in the case of the use of the metal oxynitrides provided that such gas is limited to a small amount. When a metal target made of a first metal component and another metal target made of a second metal component different from the first metal component are used in combination, it is possible to form a compound of the second metal component by using oxygen gas in the case of forming a metal oxide as a compound of the second metal component, nitrogen gas in the case of forming a metal nitride as a compound of the second metal component, or oxygen gas, nitrogen gas or nitric oxide gas in the case of forming a metal oxynitride as a compound of the second metal component. No particular limitation is imposed on the method for applying electric powers to the targets, and a suitable method can be chosen depending on the kind of the composite thin film to be formed. RF power supply, AC power supply and DC power supply are all usable. Different power supplies can be used for the respective targets.

Concerning the first and the second metal components, it is preferred to use as the first metal component a metal selected from the group consisting of Zn, Cr, Al, Cu, Si, Ti, Ag, Mn, Fe, Co, Cd, Ni, Zr, Nb, Mo, In, Sn, Sb, Hf, Ta, W, and Mg, and as the second metal component a metal different from the first metal component selected from the group, especially a metal different from the first metal component selected from the group consisting of Zn, Ti, Nb, In, Sn, Sb, and W.

Especially when the metal compound is a titanium compound (when the second metal component is Ti), the first metal component is suitably a metal selected from the group consisting of Zn, Cr, Al, Cu, Si, Ag, Mn, Fe, Co, Cd, Ni, Zr, Nb, Mo, In, Sn, Sb, Hf, Ta, W, and Mg.

It is to be noted that in any combination of the first metal component and the second metal component, the first metal component and the second metal component may preferably be in such a combination that only the metal portions can be dissolved out of the composite thin film in an aqueous acid solution or aqueous alkali solution.

The thickness of the composite thin film may preferably be from 10 nm to 20 µm, notably from 100 nm to 10 µm, although it can be selectively determined as desired depending on the application purpose of the porous thin film.

In the method according to the first embodiment of the present invention for the formation of the porous thin film, the porous thin film is formed by removing only the metal portions from the composite thin film. In this case, the porous thin film is obtained as a porous metal compound thin film. When the first metal component and the second metal component are in such a combination that only the metal portions can be dissolved out of the composite thin film in an aqueous acid solution or an aqueous alkali solution, it is possible to adopt, as a method for removing the metal portions, a method of dissolving the metal portions with the aqueous acid solution or the aqueous alkali solution and further a method of immersing the composite thin film in the aqueous acid solution or the aqueous alkali solution.

A suitable aqueous acid solution or aqueous alkali solution can be chosen as desired in conformity with the kinds and combination of the first and the second metal components. Usable acids can include hydrochloric acid, sulfuric acid, nitric acid, phosphoric acid, acetic acid, hydrofluoric acid, chromic acid, hydrogen peroxide, perchloric acid, chloric acid, chlorous acid, hypochlorous acid, citric acid, oxalic acid, hydrogen bromides, and the like. They can be used as aqueous solutions of single acids or mixed acids obtained by mixing them. Depending on the metals to be dissolved, it is also possible to use a mixed aqueous solution of a mixed acid and a metal chloride such as ferric chloride or a metal sulfide. As the aqueous alkali solution, on the other hand, it is possible to use an aqueous solution of sodium hydroxide or potassium hydroxide or aqueous ammonia. It is to be noted that the concentration and composition of the aqueous acid solution or aqueous alkali solution can be selectively determined as desired depending on the kinds of the metals to be dissolved.

In the first embodiment, it is preferred to conduct baking after the removal of the metal portions. This baking makes it possible to provide the resulting porous thin film with higher strength.

A description will next be made about the method according to the second embodiment of the present invention for the formation of a porous thin film.

The method according to the second embodiment of the present invention for the formation of a porous thin film forms the porous thin film by forming on a substrate a composite thin film in which metal portions composed of a first metal component and metal portions composed of a second metal component different from the first metal component are randomly distributed together, and then, removing only one metal portions of the first metal portions and the second metal portions from the composite thin film.

In this second embodiment, no particular limitation is imposed on the kind of the substrate to be processed, and a desired substrate can be selected depending on the application purpose of the porous thin film. When forming the porous thin film metal as a catalyst for a fuel cell, a high molecular electrolyte film useful in the fuel cell oxide can be used as a substrate.

In the second embodiment, the composite thin film can be formed by arranging a first metal target composed of the first metal component and a second metal target composed of the second metal component different from the first metal component in a chamber, and simultaneously applying electric powers to these targets to perform sputtering.

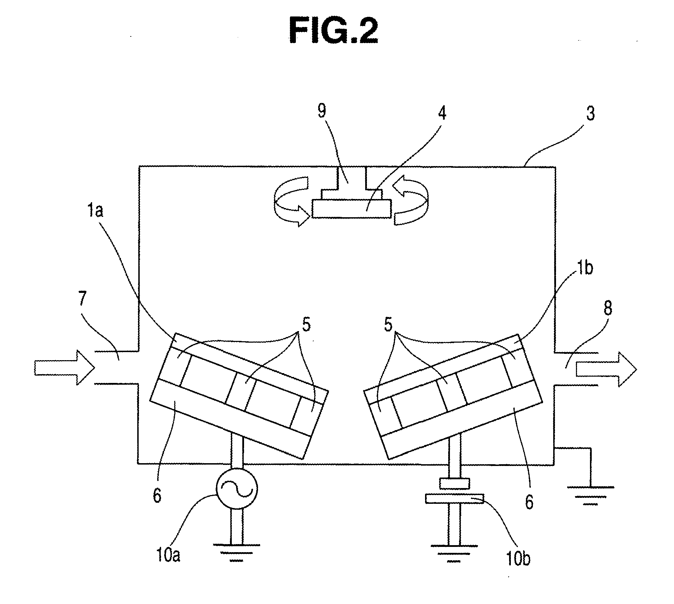

As such a method, a composite thin film can be formed, for example, as illustrated in FIG. 2, by conducting sputtering while rotating a substrate 4, on which the composite thin film is to be formed, with a film-forming surface being directed toward sputtering surfaces of targets 1a, 1b in a sputtering atmosphere formed by arranging a first metal target 1a composed of a first metal component and a second metal target 1b composed of a second metal component different from the first metal component in a chamber 3 and simultaneously applying electric powers to these targets 1a, 1b (the sputtering atmosphere being formed primarily in a space extending from the sputtering surfaces of the first metal target 1a and the second metal target 1b toward the side of the substrate 4). It is to be noted that in FIG. 1, there are shown the magnets 5, the target electrodes 6, the gas inlet port 7, the gas outlet port (evacuation port) 8, the rotary support 9, the RF power supply 10a, and the DC power supply 10b.

The formation of a composite thin film by such a method makes it possible to obtain the composite thin film in such a form that fine first metal portions composed of the first metal component and fine second metal compound portions composed of the second metal component are highly distributed together. As the substrate is rotated especially in the illustrated example, the state of distribution of the first metal portions and the second metal portions in the direction of the plane of the composite thin film can be controlled uniform. In this case, it is also possible to change the ratio of the first metal portions to the second metal portions by altering the electric powers to be applied to the respective targets.

As sputtering gas, an inert gas such as helium or argon can be used. No particular limitation is imposed on the method for applying electric powers to the targets, and a suitable method can be chosen depending on the kind of the composite thin film to be formed. RF power supply, AC power supply, and DC power supply are all usable. Different power supplies can be used for the respective targets.

Concerning the first and the second metal components, it is preferred to use as the first metal component a metal selected from the group consisting of Pt, Ru, Ir, Rh, Zn, Cr, Al, Cu, Si, Ti, Ag, Mn, Fe, Co, Cd, Ni, Zr, Nb, Mo, In, Sn, Sb, Hf, Ta, W, and Mg, and as the second metal component, a metal different from the first metal component and selected from the group.

It is to be noted that in any combination of the first metal component and the second metal component, the first metal component and the second metal component may preferably be in such a combination that only one of the metal components can be dissolved out of the composite thin film in an aqueous acid solution or aqueous alkali solution.

The thickness of the composite thin film may preferably be from 1 to 500 nm, notably from 10 to 50 nm, although it can be selectively determined as desired depending on the application purpose of the porous thin film.

In the method according to the second embodiment of the present invention for the formation of the porous thin film, the porous thin film is formed by removing only one metal portions of the first metal portions and the second metal portions from the composite thin film. In this case, the porous thin film is obtained as a porous metal thin film. When the first metal component and the second metal component are in such a combination that only one metal portions of the first metal portions and the second metal portions can be dissolved out of the composite thin film in an aqueous acid solution or an aqueous alkali solution, it is possible to adopt, as a method for removing the metal portions, a method of dissolving the one metal portions of the first metal portions and the second metal portions with the aqueous acid solution or the aqueous alkali solution and further a method of immersing the composite thin film in the aqueous acid solution or the aqueous alkali solution.

A suitable aqueous acid solution or aqueous alkali solution can be chosen as desired in conformity with the kinds and combination of the first and the second metal components. Usable acids can include hydrochloric acid, sulfuric acid, nitric acid, phosphoric acid, acetic acid, hydrofluoric acid, chromic acid, hydrogen peroxide, perchloric acid, chloric acid, chlorous acid, hypochlorous acid, citric acid, oxalic acid, hydrogen bromides, and the like. They can be used as aqueous solutions of single acids or mixed acids obtained by mixing them. Depending on the metal to be dissolved, it is also possible to use a mixed aqueous solution of a mixed acid and a metal chloride such as ferric chloride or a metal sulfide. As the aqueous alkali solution, on the other hand, it is possible to use an aqueous solution of sodium hydroxide or potassium hydroxide or aqueous ammonia. It is to be noted that the concentration and composition of the aqueous acid solution or aqueous alkali solution can be selectively determined as desired depending on the kind of the metal to be dissolved.

### EXAMPLES

The present invention will hereinafter be described specifically on the basis of examples and comparative examples. It should, however, be borne in mind that the present invention is not limited to the following examples.

### Example 1

### Formation of porous thin film (metal oxide semiconductor thin film for solar cell electrode)

In a magnetron DC sputtering apparatus, a TiOx ("TXO", product of Asahi Glass Ceramics Co., Ltd.) target and Zn target were arranged, and a glass substrate coated with fluorine-doped tin oxide was arranged as a substrate in a vacuum chamber. After evacuated to 5×10⁻⁴ Pa by a turbo-molecular pump, Ar gas and O₂ gas were introduced at flow rates of 99 sccm and 1 sccm, respectively, as a mixed gas to adjust the pressure to 0.5 Pa, 1 kW electric power and 100 W electric power were applied to the TiOx target and Zn target, respectively, to perform sputtering, thereby forming a TiOx/Zn composite thin film of about 1,500 nm on a conductive surface of the glass substrate having been coated with fluorine-doped tin oxide.

The glass substrate coated with fluorine-doped tin oxide and carrying the composite thin film formed thereon was then immersed at room temperature for 30 minutes in a 1N aqueous solution of sulfuric acid to dissolve out and remove Zn from the composite thin film. Further, baking was conducted at 450°C for 30 minutes in the surrounding air atmosphere to form a porous thin film of TiOx.

### Adsorption of spectral sensitizing dye

As a solution of a spectral sensitizing dye, a 3×10⁻⁴ mol/L ruthenium (II) cis-di(thiocyanato)-bis(2,2'-bipyridyl-4-dicarboxylate-4'-tetrabutylammonium carboxylate)-ethanol solution was prepared. The glass substrate coated with fluorine-doped tin oxide and carrying the thin film of TiOx thereon was immersed at room temperature for 18 hours in the solution such that the spectral sensitizing dye was adsorbed to afford a metal oxide semiconductor electrode. The adsorption of the spectral sensitizing dye was 8 µg per cm² of the surface area of the porous thin film of TiOx.

### Fabrication of solar cell

The metal oxide semiconductor electrode was used as one of electrodes, and as the counter electrode, a transparent conductive glass substrate coated with fluorine-doped tin oxide and carrying platinum thereon was employed. An electrolyte was placed between those two electrodes, and the thus-formed unit was sealed at side walls thereof with a resin. Lead wires were then attached to fabricate a solar cell according to the present invention. Employed as the electrolyte was one prepared by dissolving lithium iodide, 1,2-dimethyl-3-propylimidazolium iodide, iodine and t-butylpyridine at concentrations of 0.1 mol/L, 0.3 mol/L, 0.05 mol/L and 0.5 mol/L, respectively, in acetonitrile as a solvent.

When the thus-obtained solar cell was exposed to light of 100 W/cm² intensity in a solar simulator. Its Voc (open circuit voltage) was 0.62 V, its Jsc (the density of a current that flowed when the circuit was shortened) was 1.30 mA/cm², its FF (fill factor) was 0.54, and its η (conversion efficiency) was 4.35%. It was, therefore, confirmed to be excellent as a solar cell.

### Comparative Example 1

### Formation of thin film (metal oxide semiconductor thin film for solar cell electrode)

In a magnetron DC sputtering apparatus, a TiOx ("TXO", product of Asahi Glass Ceramics Co., Ltd.) target was arranged, and a glass substrate coated with fluorine-doped tin oxide was arranged as a substrate in a vacuum chamber. After evacuated to 5×10⁻⁴ Pa by a turbo-molecular pump, Ar gas and O₂ gas were introduced at flow rates of 98 sccm and 2 sccm, respectively, as a mixed gas to adjust the pressure to 0.5 Pa, 1 kW electric power was applied to the TiOx target to perform sputtering, thereby forming a TiOx thin film of about 1,000 nm on a conductive surface of the glass substrate having been coated with fluorine-doped tin oxide. Further, baking was conducted at 450°C for 30 minutes in the surrounding air atmosphere.

### Adsorption of spectral sensitizing dye

In a similar manner as in Example 1, the spectral sensitizing dye was adsorbed. The adsorption of the spectral sensitizing dye was 0.6 µg per cm² of the surface area of the porous thin film of TiOx.

### Fabrication of solar cell

In a similar manner as in Example 1, a solar cell was fabricated. Its Voc was 0.58 V, its Jsc was 0.52 mA/cm², its FF (fill factor) was 0.50, and its η (conversion efficiency) was 1.51%. The solar cell was, therefore, inferior in performance to that of Example 1.

### Comparative Example 2

### Formation of thin film (metal oxide semiconductor thin film for solar cell electrode)

In a magnetron DC sputtering apparatus, a Ti target was arranged, and a glass substrate coated with fluorine-doped tin oxide was arranged as a substrate in a vacuum chamber. After evacuated to 5x10⁻⁴ Pa by a turbo-molecular pump, Ar gas and O₂ gas were introduced at flow rates of 80 sccm and 20 sccm, respectively, as a mixed gas to adjust the pressure to 0.5 Pa, 1 kW electric power was applied to the Ti target to perform sputtering, thereby forming a TiOx thin film of about 1,000 nm on a conductive surface of the glass substrate having been coated with fluorine-doped tin oxide. Further, baking was conducted at 450°C for 30 minutes in the surrounding air atmosphere.

### Adsorption of spectral sensitizing dye

In a similar manner as in Example 1, the spectral sensitizing dye was adsorbed. The adsorption of the spectral sensitizing dye was 0.5 µg per cm² of the surface area of the porous thin film of TiOx.

### Fabrication of solar cell

In a similar manner as in Example 1, a solar cell was fabricated. Its Voc was 0.56 V, its Jsc was 0.53 mA/cm², its FF (fill factor) was 0.47, and its η (conversion efficiency) was 1.39%. The solar cell was, therefore, inferior in performance to that of Example 1.

### Example 2

### Formation of porous thin film (photocatalyst thin film)

In a magnetron DC sputtering apparatus, a TiOx ("TXO", product of Asahi Glass Ceramics Co., Ltd.) target and Zn target were arranged, and a non-alkali glass substrate was arranged as a substrate in a vacuum chamber. After evacuated to 5×10⁻⁴ Pa by a turbo-molecular pump, Ar gas and O₂ gas were introduced at flow rates of 99 sccm and 1 sccm, respectively, as a mixed gas to adjust the pressure to 0.5 Pa, 1 kW electric power and 100 W electric power were applied to the TiOx target and Zn target, respectively, to perform sputtering, thereby forming a TiOx/Zn composite thin film of about 600 nm on a surface of the non-alkali glass substrate.

The non-alkali glass substrate with the composite thin film formed thereon was then immersed at room temperature for 30 minutes in a 1N aqueous solution of sulfuric acid to dissolve out and remove Zn from the composite thin film. Further, baking was conducted at 450°C for 30 minutes in the surrounding air atmosphere to form a porous thin film of TiOx.

### Evaluation of photocatalytic performance

The non-alkali glass substrate with the porous thin film of TiOx formed thereon was immersed in 22 mL of an amaranth (red pigment) solution (3 mL/L), and was exposed to light under a 250 W extra-high pressure mercury lamp (for 20 minutes). Variations in its concentration were measured by a W-visible photometer. The decomposition rate of amaranth was as high as 87.2%.

### Comparative Example 3

### Formation of thin film (photocatalyst thin film)

In a magnetron DC sputtering apparatus, a TiOx ("TXO", product of Asahi Glass Ceramics Co., Ltd.) target was arranged, and a non-alkali glass substrate was arranged as a substrate in a vacuum chamber. After evacuated to 5×10⁻⁴ Pa by a turbo-molecular pump, Ar gas and O₂ gas were introduced at flow rates of 98 sccm and 2 sccm, respectively, as a mixed gas to adjust the pressure to 0.5 Pa, 1 kW electric power was applied to the TiOx target to perform sputtering, thereby forming a TiOx thin film of about 300 nm on a surface of the non-alkali glass substrate. Further, baking was conducted at 450°C for 30 minutes in the surrounding air atmosphere.

### Evaluation of photocatalytic performance

In a similar manner as in Example 2, photocatalytic performance was evaluated. The decomposition rate of amaranth by the thin film was 43.4%. The thin film was, therefore, inferior in decomposition performance to that of Example 2.

### Comparative Example 4

### Formation of thin film (photocatalyst thin film)

In a magnetron DC sputtering apparatus, a Ti target was arranged, and a non-alkali glass substrate was arranged as a substrate in a vacuum chamber. After evacuated to 5×10⁻⁴ Pa by a turbo-molecular pump, Ar gas and O₂ gas were introduced at flow rates of 80 sccm and 20 sccm, respectively, as a mixed gas to adjust the pressure to 0.5 Pa, 1 kW electric power was applied to the Ti target to perform sputtering, thereby forming a TiOx thin film of about 300 nm on a surface of the non-alkali glass substrate. Further, baking was conducted at 450°C for 30 minutes in the surrounding air atmosphere.

### Evaluation of photocatalytic performance

In a similar manner as in Example 2, photocatalytic performance was evaluated. The decomposition rate of amaranth by the thin film was 39.7%. The thin film was, therefore, inferior in decomposition performance to that of Example 2.

### Example 3

### Formation of porous thin film (reaction layer for fuel cell)

In a magnetron DC sputtering apparatus, a Pt target and Zn target were arranged as targets, and "NAFION 112" (product of E.I. Du Pont de Nemours & Co., Inc.), an electrolyte film, was arranged as a substrate in a vacuum chamber. After evacuated to 5×10⁻⁴ Pa by a turbo-molecular pump, Ar gas was introduced at a flow rate of 100 sccm to adjust the pressure to 0.5 Pa, 1 kW electric power and 100 W electric power were applied to the Pt target and Zn target, respectively, to perform sputtering, thereby forming a Pt/Zn composite thin film of 20 nm on a surface of "NAFION 112" as the electrolyte film. In addition, the above processing was also applied to the opposite side of the electrolyte film to obtain an electrolyte film with Pt/Zn composite thin films of 20 nm formed on both sides of the electrolyte film.

The electrolyte film with the composite thin film formed thereon was then immersed at room temperature for 30 minutes in a 1N aqueous solution of sulfuric acid to dissolve out and remove Zn from the composite thin film, thereby forming a porous thin film of Pt.

### Formation of film electrode stack

Printed (coated) on the thus-obtained electrolyte film with the porous thin film of Pt on both sides thereof was a carbon paste, which had been prepared by kneading carbon particles, the particle size of which was 50 nm, and a solution of "NAFION 117" (product of E.I. Du Pont de Nemours & Co., Inc.) of the same components as the electrolyte film into a paste form.

Carbon paper sheets, which were to act as an anode and cathode, respectively, were then placed on the opposite sides of the electrolyte film with the carbon paste coated thereon, and the resulting preform was subjected to hot pressing at a temperature of 120°C under a pressure of 5 MPa for 10 minutes to form a film electrode stack.

### Fabrication and evaluation of fuel cell

The thus-obtained film electrode stack was held between graphite-made separators to fabricate a solar cell. Humidified hydrogen and humidified oxygen were supplied from the side of the anode and from the side of the cathode, respectively, to operate the fuel cell, and its current-voltage characteristics were measured. The open circuit voltage was 0.82 V, and the critical current density was 0.33 A/cm² .

### Comparative Example 5

### Formation of thin film (reaction layer for fuel cell)

In a magnetron DC sputtering apparatus, a Pt target was arranged as a target, and "NAFION 112" (product of E.I. Du Pont de Nemours & Co., Inc.), an electrolyte film, was arranged as a substrate in a vacuum chamber. After evacuated to 5×10⁻⁴ Pa by a turbo-molecular pump, Ar gas was introduced at a flow rate of 100 sccm to adjust the pressure to 0.5 Pa, 1 kW electric power was applied to the Pt target to perform sputtering, thereby forming a Pt thin film of 20 nm on a surface of "NAFION 112" as the electrolyte film. In addition, the above processing was also applied to the opposite side of the electrolyte film to obtain an electrolyte film with Pt thin films of 20 nm formed on both sides of the electrolyte film.

### Formation of film electrode stack

A film electrode stack was formed in a similar manner as in Example 3.

### Fabrication and evaluation of fuel cell

A fuel cell was fabricated in a similar manner as in Example 3, and its current-voltage characteristics were measured. The open circuit voltage was 0.66 V, and the critical current density was 0.17 A/cm². The fuel cell was, therefore, inferior in fuel cell performance to that of Example 3.

## Claims

1. A method for forming a porous thin film, comprising the step of forming on a substrate a composite thin film in which metal portions composed of a first metal component and metal compound portions composed of a compound of a second metal component different from said first metal component are randomly distributed together, and then, removing only said metal portions from said composite thin film.

2. A method for forming a porous thin film according to claim 1, wherein said composite thin film is formed by arranging a metal target composed of said first metal component and a metal compound target composed of said compound of said second metal component different from said first metal component in a chamber, and simultaneously applying electric powers to said targets to perform sputtering.

3. A method for forming a porous thin film according to claim 1 or 2, wherein said metal compound is a metal oxide, metal nitride or metal oxynitride.

4. A method for forming a porous thin film according to any one of claims 1 to 3, wherein said first metal component is at least one metal selected from the group consisting of Zn, Cr, Al, Cu, Si, Ti, Ag, Mn, Fe, Co, Cd, Ni, Zr, Nb, Mo, In, Sn, Sb, Hf, Ta, W, and Mg, and said second metal component is at least one metal different from said first metal component and selected from said group.

5. A method for forming a porous thin film according to any one of claims 1 to 3, wherein said first metal component is at least one metal selected from the group consisting of Zn, Cr, Al, Cu, Si, Ti, Ag, Mn, Fe, Co, Cd, Ni, Zr, Nb, Mo, In, Sn, Sb, Hf, Ta, W, and Mg, and said second metal component is at least one metal different from said first metal component and selected from the group consisting of Zn, Ti, Nb, In, Sn, Sb and W.

6. A method for forming a porous thin film according to any one of claims 1 to 3, wherein said first metal component is at least one metal selected from the group consisting of Zn, Cr, Al, Cu, Si, Ag, Mn, Fe, Co, Cd, Ni, Zr, Nb, Mo, In, Sn, Sb, Hf, Ta, W, and Mg, and said second metal component is Ti.

7. A method for forming a porous thin film according to any one of claims 1 to 6, wherein said first metal component and second metal component are in such a combination that only said metal portions can be dissolved out of said composite thin film in an aqueous acid solution or aqueous alkali solution.

8. A method for forming a porous thin film according to claim 7, wherein said removal of said metal portions comprises dissolving said metal portions with said aqueous acid solution or aqueous alkali solution.

9. A method for forming a porous thin film according to any one of claims 1 to 8, further comprising the step of conducting baking after said metal portions are removed.

10. A method for forming a porous thin film, comprising the step of forming on a substrate a composite thin film in which first metal portions composed of a first metal component and second metal portions composed of a second metal component different from said first metal component are randomly distributed together, and then, removing only one metal portions of said first metal portions and said second metal portions from said composite thin film.

11. A method for forming a porous thin film according to claim 10, wherein said composite thin film is formed by arranging a first metal target composed of said first metal component and a second metal target composed of said second metal component different from said first metal component in a chamber, and simultaneously applying electric powers to said targets to perform sputtering.

12. A method for forming a porous thin film according to claim 10 or 11, wherein said first metal component is at least one metal selected from the group consisting of Pt, Ru, Ir, Rh, Zn, Cr, Al, Cu, Si, Ti, Ag, Mn, Fe, Co, Cd, Ni, Zr, Nb, Mo, In, Sn, Sb, Hf, Ta, W, and Mg, and said second metal component is at least one metal different from said first metal component and selected from said group.

13. A method for forming a porous thin film according to any one of claims 10 to 12, wherein said first metal component and second metal component are in such a combination that said metal portions of only one metal component can be dissolved out of said composite thin film in an aqueous acid solution or aqueous alkali solution.

14. A method for forming a porous thin film according to claim 13, wherein said removal of said metal portions comprises dissolving only one metal portions of said first metal portions and second metal portions with said aqueous acid solution or aqueous alkali solution.
